Europäisches Patentamt

European Patent Office

Office européen des brevets

(11) Publication number: 0 380 176
A1

# EUROPEAN PATENT APPLICATION

(21) Application number: 90200153.6

(22) Date of filing: 22.01.90

(51) Int. Cl.⁵: C25D 5/12, C25D 7/00, H01L 23/495

(30) Priority: 25.01.89 NL 8900172

(43) Date of publication of application:
01.08.90 Bulletin 90/31

(84) Designated Contracting States:
AT BE CH DE DK ES FR GB GR IT LI LU NL SE

(71) Applicant: Meco Equipment Engineers B.V.
De Beverspijken 3 P.O. Box 2214
NL-5202 CE 's-Hertogenbosch(NL)

(72) Inventor: Meuldijk, Pieter Willem
Loyolalaan 62
NL-5263 AV Vught(NL)

(74) Representative: Noz, Franciscus Xaverius, Ir.
et al
Algemeen Octrooibureau P.O. Box 645
NL-5600 AP Eindhoven(NL)

(54) method for producing a solderable finish on metal frames for semiconductors.

(57) The invention relates to a method for producing a solderable finish on leadframes to be used for the manufacture of integrated circuits or other semi conductor components and made by attaching a chip to the leadframe and by connecting the chip by means of thin wires to further parts of the leadframe. Said wires are bonded or cold welded to said further parts of the leadframe. Prior to mounting the chip on the leadframe there is provided on the leadframe a solderable coating consisting of an alloy of palladium and silver having a palladium content of 10-90% by weight.

EP 0 380 176 A1

## Method for producing a solderable finish on metal frames for semiconductors

The invention relates to a method for producing a solderable finish on leadframes to be used for the manufacture of integrated circuits (IC's) or other semiconductor components as described in the pre-characterising part of claim 1.Such components are made by first attaching a chip to the leadframe,also called die bonding, followed by connecting the chip with thin wires by means of bonding or cold welding to those parts of the leads of the frame adjacent to the chip.

The leadframe used for the manufacturing of the IC's or the like are obtained by stamping these frames from metal strip stock , the metal being alloys of nickel iron, copper iron and similar copper alloys.The stamping operation is usually carried out in such a way that the individual leadframes are still attached to one another to facilitate further treatment of the leadframes.

In most cases the area designated for attaching the chip -the bonding pad-and those parts of the leads of the leadframe directly adjacent to the bonding pad require a selectively plated coating of a precious metal to provide for easy chip and wire bonding.For eutectic chip or die bonding gold is preferred as a plated coating , for epoxy die attach silver is almost universally used.

Equipment for selectively plating areas of leadframes with precious metal is disclosed in European patent 0,060,591.

After die-attach of the chip on the bonding pad the lead ends of the leadframe adjacent to the bonding pad are connected with the chip by cold welding or bonding of thin metal connecting wires.This process is called wire bonding.

After these assembly operations chip ,connecting wires and lead ends are encapsulated in plastic forming a package in such a manner that the parts of the leads of the leadframe not adjacent to the chip -the outer leads- protrude outside the package.

To make reliable connections to the leads outside the package it has been hitherto standard to apply a tin or solder coating to these outer leads to guarantee good solderability of these parts when mounted on a printed circuit board or the like.

Before a coating of tin or tin lead can be applied however, oxyde layers formed during above mentioned operations on the metal surface of the outer leads protruding outside the package must be removed.This is generally achieved by exposure of such outer leads to warm acid solutions , e.g. sulfuric or hydrochloric acid.Only after removal of such metal oxide surface coating can a reliable tin or solder layer be applied by hot dip tinning or electroplating.

Applying tin or tin lead coatings in the described manner represents an important cost factor.

Moreover danger exists of acid or other chemicals being trapped in the capillary spaces between metal of the leadframe and plastic encapsulation which ultimately will lead to failure of the product.Coating the areas of the leadframe that require solderability with tin or solder before die attach is impracterical for several reasons.

Firstly tin and solder are very soft metals.Applying such coatings before die attach and subsequent operations would result in considerable damage of the soft coatings which would make the final components unsuitable for use.

Further , a certain distance must be maintained between the selective precious metal coating and the tin or solder covered area, to avoid undesirable intermetallic reactions.This introduces the danger that the outer lead area outside the plastic encapsulation will not have been completely coated with tin or solder.

The carrier rails which during manufacture serve as interconnection between the individual leadframes are also used for guiding the components during subsequent assembly operations.Transportations of tin or solder coated carrier rails along guides in assembly operations will result in contamination of the guides with tin of tin lead and prevent smooth transport of the leadframe strip.

Finally during assembly frames are exposed during longer periods to temperatures of 160-200°C.However the preferred eutectic solder alloy of 60% tin 40% lead has a melting point of 180° which makes application of this alloy practically impossible.A pure tin coating with a melting point of 232°C would be possible,however, solderability of such a tin coating would seriously suffer by formation of copper-tin intermetallics during the prolonged exposure to hig temperatures during assembly.

In EU-A-0,132,596 a method is disclosed to coat leadframes made of nickel-iron alloy (alloy 42) with an extremely thin layer of nickel and subsequently with equally thin layers of precious metal, such as gold silver, palladium or their alloys.Use of gold is prohibitive for cost reasons.

Use of silver is undesirable , since silver on leadframes outside the plastic encapsulation tends to migrate over plastic surfaces and can therefore ultimately cause electrical shorts.

Furthermore the method disclosed in EU-A-0,132,596 is as stated only suitable for nickel-iron alloys which are bad heat conductors.It cannot be used for copper based alloys.

In practice, coatings as disclosed in EU-A-0,132.596 are solderable only when freshly prepared ; solderability however deteriorates rapidly upon ageing and almost instantly upon accelerated ageing.

Therefore a need exists still in the semiconductor industry to be provided with leadgrames or similar semi conductor elements having a solderable coating before assembly.

According the invention this can be obtained when prior to mounting the chip on the leadframe there is provided on the leadframe a solderable coating consisting of an alloy of palladium and silver having a palladium content of 10-90% by weight.

It was surprisingly found that even relatively thin coatings of a palladium silver alloy also after accelarated ageing showed perfect solderability . The palladium silver alloys were further of a hardness which will completely eliminate the risk of contamination of guides during assembly transport.

Electroplating of palladium-silver alloys in itself is known from several patents.US-A-4,465,563 - 4,478,692 - 4,741,818 disclose bath formulations for plating palladium silver alloys.Another bath formulation is disclosed in DE-A-3,609,309.Also various publications describe plating bath formulations and applications of palladium silver alloys , e.g. Metal Finishing (USA) Januari 1986,page 55 etc.,Plating and Surface Finishing (USA) June 1986 , page 88 etc. and Galvanotechnik (German) 1987,nr. 6 , page 1570 etc.

All patents and publications referred to above deal with solution compositions, working conditions and the technology of palladium silver alloy plating in general . The publication in Plating and Surface Finishing refers further to the application of palladium silver as a replacement for gold on connectors.

None of these publications refers to the application of palladium silver alloys in the sense of the object of this invention.

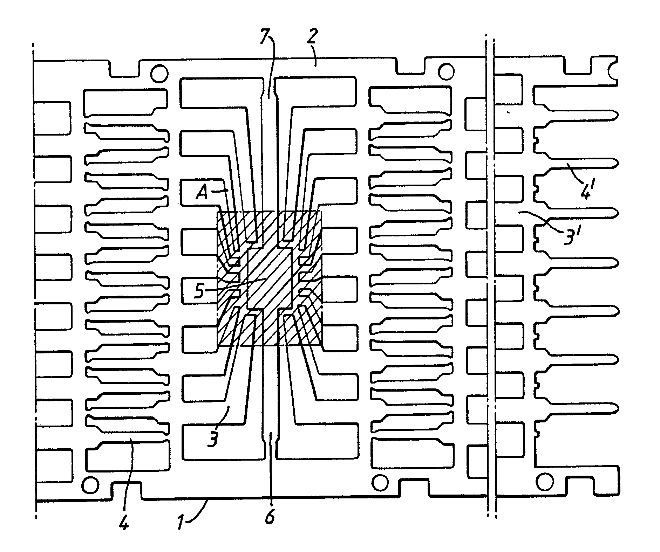

The drawing which forms part of this description shows a part of a metal strip with stamped leadframes,which are interconnected by carrier rails 1 and 2 . Each leadframe has a number of leads 3,4 and a bonding pad 5 for die attaching of a chip , which pad is connected by strips 6 and 7 with the carrier rails 1 and 2.Leadframe strips are usually stamped from copper alloy or nickel iron material.

After stamping metal strip for forming the leadframe strip consisting of interconnected leadframes,said leadframe strip can be coated with a palladium silver alloy for instance by using a method as indicated in the afore mentioned publications . Subsequently hatched area A in the drawing can be plated selectively with a precious metal as specified.

In a next operation a chip can be attached to the bonding pad 5 whereafter the ends of leads 3 which are adjacent to bonding pad 5 in the hatched area A can be connected by wire bonding with designated points of the chip.In a further assembly operation chip and wire bonds comprising hatched area A are encapsulated in plastic.

For subsequent assembly in e.g. a printed circuit board the component formed by a leadframe and encapsulated chip must be seperated from the carrier rails 1 and 2 and from adjacent components to enable connection by leads 3' of 4' to the circuit on the printed circuit board by a soldering operation . Because leads 3' and 4' were plated with a palladium silver alloy perfect solderability is guaranteed.

Good results in practical operation can be obtained with alloys containing 10-90% by weight palladium , the remainder being silver , with a thickness of 0.05 micrometer minimum,preferably however 0.1-0.15 micrometer.Larger thicknesses are also satisfacorily, but are for economic reasons less interesting.

Copper alloys , such as copper iron , are preferably first plated with nickel before palladium silver is put on.The nickellayer thickness should be minimum 0.5 micrometer preferably between 1 and 2 micrometer.Larger thicknessess are also fully satisfactorily, but in view of the low ductility danger exists for crack formation if products have to be bend in assembly operations.

Best resuluts have been obtained with an alloy containing 30% palladium and 70% silver plated to a thickness of 0.1-0.15 micrometer on a nickel underlayer if the base material was a copper alloy.Also after accelerated ageing such as described in the test specification B.S. 1872 - the Dry Heat test - solderability of such coatings was perfect.

The invention has been desribed above for palladium silver alloy plating of stamped leadframes,but it will be clear that other components or leadframes manufactured by other methods such as photo-chemical milling are included in the method of this invention.

## Claims

1. Method for producing a solderable finish on leadframes to be used for the manufacture of integrated circuits or other semi conductor components and made by attaching a chip to the leadframe and by connecting the chip by means of thin wires to further parts of the leadframe,whereby said wires are bonded or cold welded to said further parts of the leadframe , characterized in that prior to mounting the chip on the leadframe there is provided on the leadframe a solderable coating consisting of an alloy of palladium and silver having a palladium content of 10-90% by weight.

2. Method according claim 1 , characterized in that there is used an alloy of palladium and silver comprising approx. 30% palladium.

3. Method according claim 1 or 2 , characterized in that the alloy of palladium and silver is provided in a layer with a thickness of minimum 0,05 micrometer, preferably 0.10-0.15 micrometer.

4. Method according any of the preceding claims, characterized in that prior to providing the coating of paladium-silver alloy on the leadframe there is provided a coating of nickel .

5. Method according claim 4 , characterized in that the nickel is applied in a layer having a thickness of minimum 0.5 micrometer preferably 1-2 micrometer.

6. Product manufactured by using the method according any of the preceding claims.

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,D | PLATING AND SURFACE FINISHING, vol. 73, no. 6, June 1986, pages 88-94; F.I. NOBEL et al.: "Electroplated palladium-silver alloys" | 1-3,6 | C 25 D 5/12<br>C 25 D 7/00<br>H 01 L 23/495 |
| A,D | EP-A-0 132 596 (KOBAYASHI)<br>* Claims * | 4,5,6 | |
| A | US-A-4 628 165 (NOBEL) | | |
| A | GB-A-2 138 025 (FURUKAWA) | | |
| A | PATENT ABSTRACTS OF JAPAN, vol. 13, no. 142, (E-739)[3490] page 111 E 739; & JP-A-63 304 654 (HITACHI) 12-12-1988 | 1,2,3,6 | |
| | | | **TECHNICAL FIELDS SEARCHED (Int. Cl.5)**<br><br>C 24 D 5/10<br>C 25 D 5/12<br>C 25 D 3/56<br>H 01 L 23/495<br>H 01 L 23/48<br>B 23 K 35/00 |

The present search report has been drawn up for all claims

| Place of search | Date of completion of the search | Examiner |
|---|---|---|
| THE HAGUE | 06-04-1990 | VAN LEEUWEN R.H. |